Europäisches Patentamt

European Patent Office

Office européen des brevets

(11) Publication number: **0 225 342**
**B1**

# (12) EUROPEAN PATENT SPECIFICATION

(45) Date of publication of patent specification: 22.08.90

(21) Application number: 86903044.5

(22) Date of filing: 25.04.86

(86) International application number:
PCT/US86/00890

(87) International publication number:
WO 86/06658 20.11.86 Gazette 86/25

(51) Int. Cl.⁵: **B 05 D 3/00, B 05 D 3/02,
B 05 D 5/06, B 05 D 5/12,
E 04 C 2/54**

(54) METHOD OF PRODUCING TRANSPARENT, HAZE-FREE TIN OXIDE COATINGS.

(30) Priority: 14.05.85 US 733997
30.10.85 US 793023
27.11.85 US 802551

(43) Date of publication of application:
16.06.87 Bulletin 87/25

(45) Publication of the grant of the patent:
22.08.90 Bulletin 90/34

(84) Designated Contracting States:
AT BE CH DE FR GB IT LI LU NL SE

(56) References cited:
US-A-3 406 085
US-A-3 420 693
US-A-3 944 684
US-A-4 265 974
US-A-4 440 822
US-A-4 459 789
US-A-4 547 400
US-A-4 548 836
US-A-4 590 096

(73) Proprietor: M & T CHEMICALS, INC.
One Woodbridge Center
Woodbridge, New Jersey 07095 (US)

(72) Inventor: LINDNER, Georg, Heinrich
Haydnlaan, 10
NL-4384 KV Vlissingen (NL)

(74) Representative: van der Kloet-Dorleijn,
Geertruida W.F., Drs. et al
EXTERPATENT Willem Witsenplein 4
NL-2596 BK 's-Gravenhage (NL)

Courier Press, Leamington Spa, England.

**Description**

Background of the invention

This invention relates to a method for providing a transparent, haze-free tin oxide coating, which comprises vaporizing an organotin compound and contacting said vapor in an oxygen-containing atmosphere with a substrate at an elevated temperature.

Tin oxide is widely used as a coating material in optical instruments. The tin oxide coating is required to be transparent and haze-free in order to avoid interference with the optical performance of the device. A tin oxide coating also is used to reduce or cancel iridescence in glass window structures. While such tin oxide coatings function effectively for the purposes intended, they introduce haze into the system unless formed under very restrictive and disadvantageous deposition conditions. Thus, it is suggested to avoid tin tetrachloride, or any other similar compound containing a halide, which can produce an acid vapor at the hot glass surface.

U.S. 3,944,684 describes a process of the kind stated above for the deposition of tin and indium oxide films on a glass substrate; certain organotin compounds are stated as being useful, including various low-molecular weight alkyl and alkoxy tin molecules. Tetraphenyl tin is mentioned, but neither exemplified nor claimed. Although that patent discusses deposition temperatures which are within the range of those of this invention, there is no recognition that an aromatic tin halide can produce haze-free films. Further, the entire disclosure of the patent is directed to combined indium-tin coatings.

Summary of the invention

A method for providing a transparent haze-free tin oxide coating of the abovementioned type has now been found, which does not have the abovementioned drawbacks.

The process according to the invention is characterized in that the organotin compound is monophenyl tin trichloride.

As a feature of the invention, liquid monophenyltin trichloride is of low corrosivity and of low toxicity, and is rapidly decomposed in air at an elevated substrate temperature to provide transparent, haze-free tin oxide coatings. Typically, these tin oxide coatings have less than 1% haze and greater than 80% visible transmission, and are obtained in a thickness of up to 250 nm in a deposition time of less than 25 seconds at a glass temperature of about 450°C—650°C.

As another feature of the invention, the haze-free tin oxide coating can be used as an undercoat film. Thereby an overcoat film of tin oxide formed thereon will assume the haze-free characteristics of the undercoat film.

Still another feature of the invention is the use of the haze-free layer to reduce iridescence in a reflecting glass structure which includes a transparent, conductive tin oxide coating.

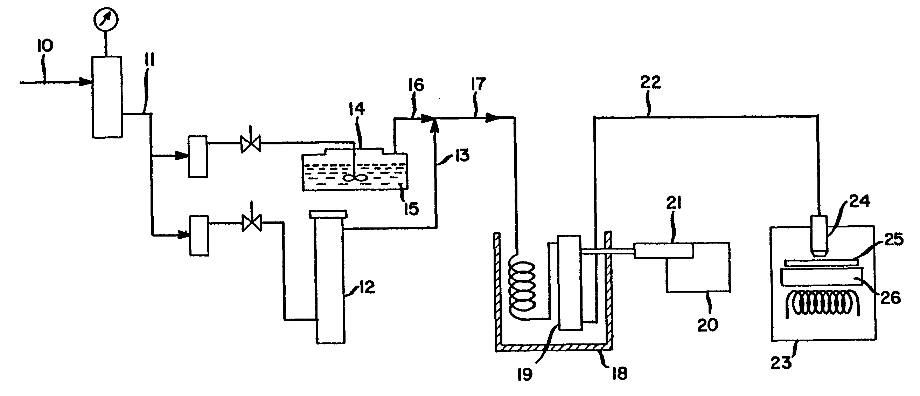

The Figure is a schematic diagram of an apparatus for carrying out the coating process of the invention.

Referring now to the Figure, there is shown a diagrammatic representation of an apparatus suitable for carrying out the process of the present invention. Accordingly, a carrier gas 10, which includes oxygen is metered through a feed line 11 at a predetermined flow rate through an air dryer tower 12 to provide a stream 13 of dry air. A separate air stream may be directed through a humidifier 14 containing a suitable quantity of water 15 to provide a wet air stream 16 at a desired relative humidity. Thereby an air stream 17, either dry or wet, may be passed through an evaporator 18 containing vessel 19 for holding liquid monophenyltin trichloride. The liquid is supplied to evaporator 18 by syringe pump 20 and syringe 21. The air stream is heated from an oil bath (not shown) to a desired vaporization temperature.

The vaporized liquid monophenyltin trichloride in the air stream 22 travels to a deposition chamber 23 having a coating nozzle 24 in which a glass substrate 25 is mounted on a plate 26 heated to a predetermined temperature. After deposition of the tin oxide coating on the glass substrate, the gaseous by-products of the deposition are exhausted.

In accordance with the invention, transparent, haze-free tin oxide coatings may be prepared over a wide range of process conditions, as described hereinafter.

Accordingly, the glass substrate suitably is held at a temperature of about 450°C to 650°C., preferably 500° to 600°C.

The vaporization temperature of liquid monophenyltin trichloride in the process suitably ranges from about 100° to 250°C., preferably about 120°C to 175°C.

The carrier gas is an oxygen-containing gas which suitably may be air, or a mixture of oxygen and an inert gas, and is preferably air.

The carrier gas may be dry or wet; preferably the water vapor concentration is less than 10 moles of water per mole of monophenyltin trichloride.

The carrier gas velocity suitably ranges from about 0.1 to about 10 m per sec.

The concentration of monophenyltin trichloride in the carrier gas suitably ranges from about $10^{-5}$ to $10^{-2}$ moles of monophenyltin trichloride per mole of carrier gas.

In general, the process of the invention produces transparent, haze-free tin oxide coatings which have less than 1% haze and greater than 80% visible transmission, and are obtained in a thickness of up to 250 nm in a deposition time of less than 25 seconds.

2

The haze content of the tin oxide coatings of the invention was determined from Gardner hazemeter measurements on glass slides coated with tin oxide deposited from monophenyltin trichloride, according to ASTM D1003-61 (Reapproved 1977)-Method A.

The visible transmittance was measured on a UV/vis spectrophotometer over the 400—800 nm region, versus air, and the % $T_{vis}$ was averaged over the wavelengths.

The film thickness was measured by the beta-back-scatter method according to British Standards Institution method BS5411: Part 12, 1981, ISO 3543—1981.

The advantages of the invention can be more readily appreciated by reference to the following specific examples in which the percent haze of tin oxide coatings on glass obtained from monophenyltin trichloride are compared to the percent haze of tin oxide coatings made from monobutyltin trichloride (Table I); and of the percent haze of coatings from monophenyltin trichloride over a range of process conditions (Table II).

TABLE I

Haze-content of tin oxide coatings obtained from monophenyltin trichloride (MPTC) and monobutyltin trichloride (MBTC)

| Example | Concentration (moles/ltr.) | Substrate Temp. (°C.) | % Haze | | |
| --- | --- | --- | --- | --- | --- |
| | | | MPTC | MBTC | Uncoated glass |
| 1 | 0.079 | 600 | 0.90 | 5.5 | |
| 2 | " | 550 | 0.75 | 2.7 | |
| 3 | " | 500 | 0.75 | 1.1 | 0.75 |

TABLE II

Haze-content of tin oxide coatings obtained from monophenyltin trichloride under different process conditions

| Example | Concentration (moles/ltr.) | Substrate Temp. (°C). | % Haze | |
| --- | --- | --- | --- | --- |
| | | | MPTC | Uncoated glass |
| 4 | 0.119 | 600 | 0.90 | |
| 5 | " | 550 | 0.75 | |
| 6 | " | 500 | 0.75 | |
| 7 | 0.159 | 600 | 0.75 | |
| 8 | " | 500 | 0.75 | 0.75 |

Dew point, Exs. 1—3, 2.4; Exs. 4—8, 12.0; vaporization temp., Exs. 1—8, 157°C.; thickness of coatings, Exs. 1—8, 190 nm; deposition times, Exs. 1—8, MPTC 6—22 seconds, Exs. 1—3, MBTC, 7—9 seconds; visible transmittance, Exs. 1—8, MPTC, 80%; Exs. 1—3, MBTC, 75%.

The data in the tables show that tin oxide coatings obtained from monophenyltin trichloride exhibit a haze of less than 1% under a wide range of process conditions, and at certain substrate temperatures show a value equal to that of uncoated glass. On the other hand, tin oxide coatings made from monobutyltin trichloride are hazy under all process conditions. Furthermore, coatings made using tin tetrachloride, ethyltin tribromide, dibutyltin dichloride, dimethyltin dichloride, methyltin trichloride, dibutyltin diacetate, tributyltin, chloride and tetrabutyltin all show haze similar or more severe than monobutyltin trichloride. In addition, under a wide range of vapor deposition conditions, monophenyltin trichloride gave superior haze-free coatings.

The reason that haze-free tin oxide coatings can be produced from monophenyltin trichloride, which is an organotin trihalide compound, is not well understood at present. However, this advantageous property may be related to the minimum of surface voids, or pitting, observed in tin oxide coatings made from this compound.

As another feature of the invention, the haze-free tin oxide coating prepared from monophentyltin

3

trichloride can be used as an undercoat film between glass and an overcoat tin oxide coating, whereupon the overcoat tin oxide coating assumes the haze-free characteristics of the undercoat film. The overcoat film then may be deposited from any tin compound which forms tin oxide coatings. If desired, a conductive ovecoat tin oxide coating may be formed by including a dopant with the tin compound. For example, such compounds as tin tetrachloride, monoalkyltin trichlorides, e.g. monobutyltin trichloride, dibutyltin diacetate, dimethyltin dichloride, and the like, may be used. Monobutyltin trichloride is a preferred source compound.

A dopant which imparts conductivity to the tin oxide overcoat may be included in the tin coating composition if desired. Such dopants include trifluoroacetic acid, trifluoroacetic anhydride, ethyl trifluoroacetate, pentafluoropropionic acid, difluorodichloromethane, monochlorodifluoromethane, 1,1-difluoroethanol, and the like.

A preferred conductive tin oxide overcoating composition is monobutyltin trichloride and trifluoroacetic acid, suitably in a composition range of about 70—99 wt.% of the organotin compound and 1—30 wt.% of the dopant.

The undercoat tin oxide film suitably has a thickness of at least 10 nm, preferably 30 nm. The tin oxide overcoating can have any desired thickness; usually for conductive coatings on glass it is about 150—250 nm.

The tin oxide coatings obtained using monophenyltin trichloride as an undercoat are haze free under a wide range of process conditions, and at certain substrate temperatures show a value substantially equal to that of uncoated glass. On the other hand, tin oxide coatings made from monobutyltin trichloride directly on glass are hazy under all process conditions.

There are provided herein also non-iridescent, haze-free, infrared reflecting glass structures including a transparent, conductive tin oxide coating which reflects infrared radiation, and a transparent, haze-free tin oxide coating made from monophenyltin trichloride, which is present to reduce iridescence in said structure. Such tin oxide coatings are also referred to herein as interference masking films.

In an embodiment, the coatings are applied on opposed surfaces of a glass sheet and the thickness of the haze-free tin oxide coating made from monophenyltin trichloride is predetermined in relation to the thickness of the conductive tin oxide coating, to provide a substantially non-iridescent, haze-free structure.

As described above, the haze-free tin oxide coating made from monophenyltin trichloride can be applied as a single layer or it can form an undercoat for subsquent layers thereon which assume the haze-free characteristics of the undercoat. The conductive tin oxide coating is formed by conventional methods, e.g. pyrolysis, chemical vapor deposition, powder coating, and cathode sputtering, and from conventional sources of doped tin oxide, e.g. dibtuyltin difluoride, dibutyltin diacetate, monobutyltin trichloride, etc. and, where necessary a dopant such as a fluorine dopant.

A double-glazed glass window article which is transparent and haze-free also is provided herein.

The interference masking (iridescence reducing) films are tin oxide films made from monophenyltin trichloride. Such interference masking films are colorless tin oxide films with a visible refeflectance high enough to mask the visible interference effect of the tin oxide infrared reflecting film. The thickness of the tin oxide masking film is selected in accordance with known criterion established to provide the desired iridescence reduction effect.

In one embodiment of these structures, an infrared reflecting coating is applied to one surface of a glass sheet and a more visible reflective masking film is deposited on the opposite surface of the glass sheet. This coated product may be used monolithically or preferably may be mounted in a multiple glazed unit.

In another embodiment, an infrared reflecting film is applied to surface of a glass sheet, while a more visibly reflective masking film applied to one surface of a second glass sheet. The two coated glass sheets are assembled into a multiple glazed window unit, preferably with both coatings facing the interior space in the unit. The preferred orientation for the multiple glazed unit in a building is with the infrared reflective film on the interior glass sheet.

In still another embodiment, both sheets of a double glazed unit are coated on both sides, with tin oxide infrared reflecting films on the interior surfaces and colorless tin oxide masking films on the exterior surfaces. The two coatings may be applied simultaneously.

In another embodiment of a double-glazed window structure, the interior surface of one glazing is infrared-reflecting, and the interior surface of the other glazing, facing each other, is iridescent-reducing made from monophenyltin trichloride.

Such articles are effective for passive solar heating applications because the high transmittance allows solar energy (light and heat) into a structure, while the high infrared reflectance and low emissivity keep heat inside the structure from being lost.

In one embodiment of the glass structures, a glass sheet, typically a glass window pane, is coated on one major surface thereof with an interference masking tin oxide coating formed by chemical vapor deposition of monophenyltin trichloride. This coating is non-conductive, since its function in the structure is only to mask or reduce iridescence without introducing haze over a wide range of desirable process conditions and within a rapid deposition rate. This coating is substantially haze-free, that is, has a percent haze of less than 1%, and, in fact, is about equal to the percent haze for uncoated glass.

A conductive infrared-reflecting tin oxide coating is provided on the opposite surface of the sheet. This coating may be made from any conventional doped tin oxide source, e.g. dibutyltin trichloride, dibutyltin diacetate, monobutyltin trichloride, and a suitable dopant, e.g. fluorine, from such sources as trifluoroacetic acid and ethyl trifluoroacetate acid.

The haze-free interference masking tin oxide layer also may be used in a double-glazed window structure enclosing an insulating air space between an inner transparent sheet and an outer transparent sheet. These sheets are formed of glass and the conductive tin oxide coatings are present on the inner surfaces of the glass, facing each other.

In a typical embodiment, there is a difference of about 1/4 wavelength between the conductive and masking coatings, e.g. the conductive coating is about 0.2 microns while the masking coating is about 0.27 microns, the difference being 0.07 microns.

## Claims

1. A method for providing a transparent, haze-free tin oxide coating, which comprises vaporizing an organotin compound and contacting said vapor in an oxygen-containing atmosphere with a substrate at an elevated temperature, characterized in that the organotin compound is monophenyltin trichloride.

2. A method according to Claim 1 further characterized in that said substrate temperature is about 450°C to 600°C.

3. A method according to Claim 1 still further characterized in that said substrate is glass.

4. A method according to Claim 1 still further characterized by forming a haze-free tin oxide undercoat film on said substrate, and thereafter depositing said desired tin oxide coating thereon, whereby the tin oxide overcoat assumes the haze-free characteristics of said undercoat.

5. A method according to Claim 4 further characterized in that said tin oxide overcoat is a conductive tin oxide coating.

6. A method according to Claim 5 further characterized in that said conductive tin oxide overcoat is formed from a monoalkylation trichloride and a fluorine dopant therewith.

7. A method according to Claim 6 wherein said conductive tin oxide cating is deposited from monobutyltin trichloride and trifluoroacetic acid.

8. A method according to Claim 4 wherein said undercoat has a thickness of at least 10 nm.

9. A method according to Claim 1 characterized by being used for making a transparent, non-iridescent, infrared-reflecting glass window structure which includes a glass sheet, an infrared-reflecting tin oxide coating on one major surface of the sheet, and an iridescence-reducing tin oxide coating on the opposed surface of the sheet, said iridescence-reducing tin oxide coating being haze-free and made by contacting said sheet with monophenyltin trichloride in an oxygen-containing atmosphere.

10. A method according to Claim 9 further characterized in that said infrared-reflecting layer includes an undercoat, haze-free tin oxide layer made from monophenyltin trichloride, and an overcoat infrared-reflecting tin oxide layer, said overcoat layer assuming the haze-free characteristic of the undercoat layer.

11. A method according to Claim 9 for making a double-glazed glass window structure including at least two transparent, non-iridescent, infrared-reflecting glass window structures further characterized by being assembled with the surfaces of the infrared-reflecting tin oxide layers facing each other.

12. A method according to Claim 11 further characterized by including a glazing having a transparent, infrared-reflecting layer on the interior surface thereof, and an iridescent-reducing layer on the interior surface of the other glazing.

## Patentansprüche

1. Verfahren zur Bildung einer durchsichtigen, trübungsfreien Zinnoxidbeschichtung, indem man eine Organozinnverbindung verdampft und den Dampf in einer sauerstoffhaltigen Atmosphäre mit einem auf einer erhöhten Temperatur gehaltenen Substrat in Berührung bringt, dadurch gekennzeichnet, daß die Organozinnverbindung Monophenylzinntrichlorid ist.

2. Verfahren nach Anspruch 1, weiters dadurch gekennzeichnet, daß die Substrattemperatur etwa 450 bis 600°C beträgt.

3. Verfahren nach Anspruch 1, weiters dadurch gekennzeichnet, daß das Substrat Glas ist.

4. Verfahren nach Anspruch 1, weiters dadurch gekennzeichnet, daß man auf dem Substrat einem trübungsfreien Zinnoxidgrundschichtfilm bildet und sodann darauf die gewünschte Zinnoxidschicht abscheidet, wobei die Zinnoxiddeckschicht die trübungsfreien Eigenschaften der Grundschicht annimmt.

5. Verfahren nach Anspruch 4, weiters dadurch gekennzeichnet, daß die Zinnoxiddeckschicht eine leitende Zinnoxidschicht ist.

6. Verfahren nach Anspruch 5, weiters dadurch gekennzeichnet, daß die leitende Zinnoxiddeckschicht aus einem Monoalkylzinntrichlorid und einem Fluor-Dotiermittel hierfür gebildet wird.

7. Verfahren nach Anspruch 6, dadurch gekennzeichnet, daß die leitende Zinnoxidschicht aus Monobutyltinntrichlorid und Trifluoressigsäure abgeschieden wird.

8. Verfahren nach Anspruch 4, dadurch gekennzeichnet, daß die Grundschicht eine Dicke von wenigstens 10 nm hat.

9. Verfahren nach Anspruch 1, dadurch gekennzeichnet, daß es zur Herstellung einer durchsichtigen, nicht-irisierenden, Infrarot-reflektierenden Glasfensterkonstruktion verwendet wird, welche aus einer Glastafel, einer Infrarot-reflektierenden Zinnoxidschicht auf einer Hauptfläche der Tafel, und einer das Irisieren reduzierenden Zinnoxidschicht auf der entgegengesetzten Fläche de Tafel besteht, wobei die das Irisieren reduzierende Zinnoxidschicht trübungsfrei ist und hergestellt wird, indem man die Tafel mit Monophenylzinntrichlorid in einer sauerstoffhaltigen Atmosphäre in Berührung bringt.

10. Verfahren nach Anspruch 9, weiters dadurch gekennzeichnet, daß die Infrarot-reflektierende Schicht aus einer trübungsfreien Zinnoxidgrundschicht, hergestellt aus Monophenylzinntrichlorid, und einer Infrarot-reflektierenden Zinnoxiddeckschicht besteht, welche Deckschicht die trübungsfreien Eigenschaften der Grundschicht annimmt.

11. Verfahren nach Anspruch 9 zur Herstellung einer Doppelglasfensterkonstruktion mit wenigstens zwei durchsichtigen nicht-irisierenden, Irfrarot-reflektierenden Glasfensterbauteilen, weiters dadurch gekennzeichnet, daß sie mit einander gegenüberliegenden Infrarot-reflektierenden Zinnoxidschichten zusammengebaut ist.

12. Verfahren nach Anspruch 11, weiters dadurch gekennzeichnet, daß eine Verglasung mit einer auf der Innenseite derselben aufgebrachten Infrarot-reflektierenden Schicht und eine das Irisieren reduzierende Schicht auf der Innenfläche der anderen Verglasung vorgesehen ist.

**Revendications**

1. Un procédé de fabrication d'un revêtement transparent, exempt de voile à base d'oxyde d'étain, qui comprend la vaporisation d'un composé organostannique et la mise en contact de ladite vapeur, dans une atmosphère contenant de l'oxygène, avec un substrat à une température élevée, caractérisé en ce que le composé organostannique est du trichlorure de monophényl-étain.

2. Un procédé selon la revendication 1, caractérisé de plus en ce que la température dudit substrat est comprise entre environ 450°C et environ 600°C.

3. Un procédé selon la revendication 1, caractérisé de plus en ce que ledit substrat est du verre.

4. Un procédé selon la revendication 1, caractérisé de plus par la formation d'une sous-couche de revêtement exempt de voile à base d'oxyde d'étain sur ledit substrat, et par le dépôt ultérieur sur celle-ci du revêtement à base d'oxyde d'étain recherché, la couche supérieure de revêtement acquérant les caractéristiques non-voilantes de ladite sous-couche.

5. Un procédé selon la revendication 4, caractérisé de plus en ce que ladite couche supérieure de revêtement à base d'oxyde d'étain est un revêtement conducteur à base d'oxyde d'étain.

6. Un procédé selon la revendication 5, caractérisé de plus en ce que ladite couche supérieure de revêtement à base d'oxyde d'étain est obtenue à partir de trichlorure de monoalkyl-étain et d'un dopant fluoré.

7. Un procédé selon la revendication 6, dans lequel ledit revêtement conducteur à base d'oxyde d'étain est obtenu par déposition à partir de trichlorure de monobutyl-étain et d'acide trifluoroacétique.

8. Un procédé selon la revendication 4, dans lequel ladite sous-couche de revêtement a une épaisseur d'au moins 10 nm.

9. Un procédé selon la revendication 1, caractérisé en ce qu'il est utilisé pour fabriquer une structure pour fenêtre en verre transparent, non-iridescent, réfléchissant l'infrarouge qui comprend un carreau de verre, un revêtement réfléchissant l'infrarouge à base d'oxyde d'étain sur une surface principale du carreau, et un revêtement réduisant l'iridescence à base d'oyxde d'étain sur la surface opposée du carreau, ledit revêtement réduisant l'iridescence à base d'oxyde d'étain étant exempt de voile et obtenu par mise en contact dudit carreau avec du trichlorure de monophényl-étain dans une atmosphère contenant de l'oxygène.

10. Un procédé selon la revendication 9, caractérisé de plus en ce que ladite couche réfléchissant l'infrarouge comprend une sous-couche de revêtement exempte de voile à base d'oyxde d'étain obtenue à partir de trichlorure de monophénylétain, et une couche supérieure de revêtement réfléchissant l'infrarouge, ladite couche supérieure de revêtement acquérant les caractéristiques non-voilantes de la sous-couche de revêtement.

11. Un procédé selon la revendication 9 de fabrication d'un double-vitrage, comprenant au moins deux structures pour fenêtre en verre transparent, non-iridescent, réfléchissant l'infrarouge caractérisées de plus en ce qu'elles sont assemblées les surfaces des revêtements réfléchissant l'infrarouge à base d'oxyde d'étain en face l'une de l'autre.

12. Un procédé selon la revendication 11, caractérisé de plus en ce qu'il comprend un carreau de verre muni d'une couche transparente, réfléchissant l'infrarouge sur la surface intérieure de celui-ci, et une couche réduisant l'iridescence sur la surface intérieure de l'autre carreau de verre.